# EUROPEAN PATENT APPLICATION

(11) **EP 1 703 294 A1**
(43) Date of publication of application: **20.09.2006**
(21) Application number: 06005054.9
(22) Date of filing: 13.03.2006
(51) Int. Cl.: G01R 31/36, G06F 12/06

(54) **Battery controller**

(30) Priority: 17.03.2005 JP 2005077848
(71) Applicant: Shin-Kobe Electric Machinery Co., Ltd., Chuo-ku Tokyo 104-0044 (JP)
(72) Inventor: Emori, Akihiko c/o Hitachi, Ltd., Chiyoda-ku Tokyo 100-8220 (JP); Kawahara, Youhei c/o Hitachi, Ltd., Chiyoda-ku Tokyo 100-8220 (JP); Takahashi, Hirotaka c/o Hitachi, Ltd., Chiyoda-ku Tokyo 100-8220 (JP); Murabayashi, Fumio c/o Hitachi, Ltd., Chiyoda-ku Tokyo 100-8220 (JP); Hirasawa, Tokiyoshi, 8-1, Akashi-cho Chuo-ku Tokyo 104-0044 (JP); Okoshi, Tetsuro, 8-1, Akashi-cho Chuo-ku Tokyo 104-0044 (JP)
(74) Representative: Beetz & Partner

(57) **Abstract**

The present invention relates to a battery controller which is able to secure the number of rewrite time as required without replacement.

The battery controller including a plurality of memory groups 104a to 104n comprising nonvolatile memories rewritable on the basis of one unit or plural units, a switch (103) for selecting a memory group and a reader/writer 102 for writing or reading data into or from the memory groups, wherein the switch (103) selects sequentially a memory group, according to a signal for writing from outside.

## Description

### FIELD OF THE INVENTION

The invention relates to a battery controller, and in particular, to a battery controller for detecting and controlling the state of an electrical charge storage means such as a lead storage battery, a lithium secondary cell, a nickel-hydrogen cell, an electric double-layer capacitor.

### BACKGROUND OF THE INVENTION

A battery controller for detecting and controlling the state of an electrical charge storage means is utilized for a power supply system, a decentralized power storage system, or an electric vehicle with an electrical charge storage means such as a storage battery in order to make safe and effective use thereof. The state of an electrical charge storage means includes the state of charge (referred to SOC after an acronym for State Of Charge) indicating to what extent it has been charged, or to what extent dischargeable electrical charge remains, or the state of health (referred to SOH after an acronym for State Of Health) indicating an amount of the actual capacity of the electrical charge storage means that remains therein or to what extent the electrical charge storage means has been depleted and weakened, or degree of depletion.

With a further advance towards more use of IT and more electrical support in a vehicle, need has arisen for a power source with a highly reliable battery or having diagnostic function.

In order to provide diagnostic function thereto, it is necessary to have any kind of nonvolatile memory means. The nonvolatile memory includes a EEPROM (Electrically Erasable and Programmable Read Only Memory).

The EEPROM is a nonvolatile semiconductor memory for writing information of 2 bits or more by means of whether or not electric charge is accumulated in a floating gate, and for reading information according to a change in continuity state between a source region and a drain region due to on-off of the electric charge in floating gate.

A conventional flash EEPROM of split-gate type erases information by using the concentration of electric field on a protrusion of floating gate. Such concentration of electric field on a protrusion depletes a portion of the tunnel insulating film around the protrusion more intensively and earlier than the other part.

This causes a cell life shortened, in other words, it makes possible writing / erasing on the flash EEPROM less times, so it is desirable to make cell life longer and to increase the number of times for possible writing and erasing. Then, there has been contrived a method to increase the number of times for possible writing / erasing with a device itself {for example, JP Unexamined Patent Publicatiozz(Kokai) No. 11-254088 A (1999)}.

Further, there has also been contrived a novel circuitry for alarming up on the number of writing / erasing times reaching a threshold value {for example, JP Unexamined Patent Publication(Kokai) No. 2002-25281 A}.

### SUMMARY OF THE INVENTION

However, a conventional EEPROM has a limit to the number of rewrite times so that it is necessary to replace such memory in the case of application exceeding the limit, and from the viewpoint of economics and maintenance, it is desirable to have a memory unnecessary of such replacement.

Under the circumstances, the present invention has been developed, aiming to provide a battery controller which is able to secure the number of rewrite times as required without replacement of memory.

According to one aspect of the present invention, there is provided a battery controller for measuring at least one of voltage, current, and temperature of a secondary battery to compute state information of the secondary battery, the battery controller comprising a memory for retaining the state information of the secondary battery,
characterized in that
the memory is provided with a plurality of memory groups each comprising nonvolatile memories rewritable on the basis of one unit or plural units,
a switch for selecting a memory group, and
a reader/writer for writing or reading the state information of the secondary battery into or from the memory group as selected.

Further, according to another aspect of the present invention, there is provided a battery controller for measuring at least one of voltage, current, and temperature of a secondary battery to compute the state information of the secondary battery, the battery controller comprising a memory for retaining the state information of the secondary battery, the memory being provided with a plurality of nonvolatile memory groups each comprising nonvolatile memory rewritable on the basis of one unit or plural units, readers/writers of data mounted in correspondence with each of the nonvolatile memory groups, and a switch for selecting a memory group and a reader/writer in correspondence with said memory group,
characterized in that
the selection of a memory group as well as a reader/writer is executed by changing over the switch, and
the state information of the secondary battery is written into, or read from the memory group as selected by the reader/writer as selected.

The battery controller according to the present invention is preferably to select sequentially a memory group other than the one already selected, according to a signal for writing from outside.

The battery controller according to the present invention is preferably to comprise a counter for the number of rewrite times of each memory group and to switch the memory group according to the number of rewrite times as counted by the counter.

The battery controller according to the present invention is preferably to switch the memory group according to the error information on writing into the memory group as selected.

The battery controller according to the present invention is preferably to comprise an access means for reading or writing data retained by a memory group or into a memory group, from outside.

The battery controller according to the present invention is preferably to comprise a communication circuit for sending or receiving the state information of the secondary battery so as to read or write data from or into an external equipment by means of wireless communication.

With the battery controller according to the present invention, it is possible to increase the number of rewrite times by a factor of "n", to record a history of preceding data acquired before by n-times of rewrite, to reinforce a data-backup function, and to reduce the capacities of ROMs and RAMs, necessary for the function and operation of a microcomputer. The above mentioned features may be combined in any way, partly or as a whole.

### BRIEF DESCRIPTION OF THE DRA WINGS

Fig. 1 is a block diagram showing Embodiment 1 of a battery controller according to the invention, applied to an electric power train of a hybrid vehicle;
Fig. 2 is a block diagram showing Embodiment 2 of a battery controller according to the invention, applied to an electric power train of a hybrid vehicle;
Fig. 3 is a block diagram showing Embodiment 3 of a battery controller according to the invention, applied to an electric power train of a hybrid vehicle;
Fig. 4 is a block diagram showing Embodiment 4 of a battery controller according to the invention, applied to an electric power train of a hybrid vehicle;
Fig. 5 is a block diagram showing Embodiment 5 of a battery controller according to the invention, applied to a vehicle power supply system; and
Fig. 6 is a block diagram showing Embodiment 6 of a battery controller according to the invention, applied to a decentralized power storage system.

### DETAILED DESCRIPTION OF THE PREFERRED EMBODIMENTS

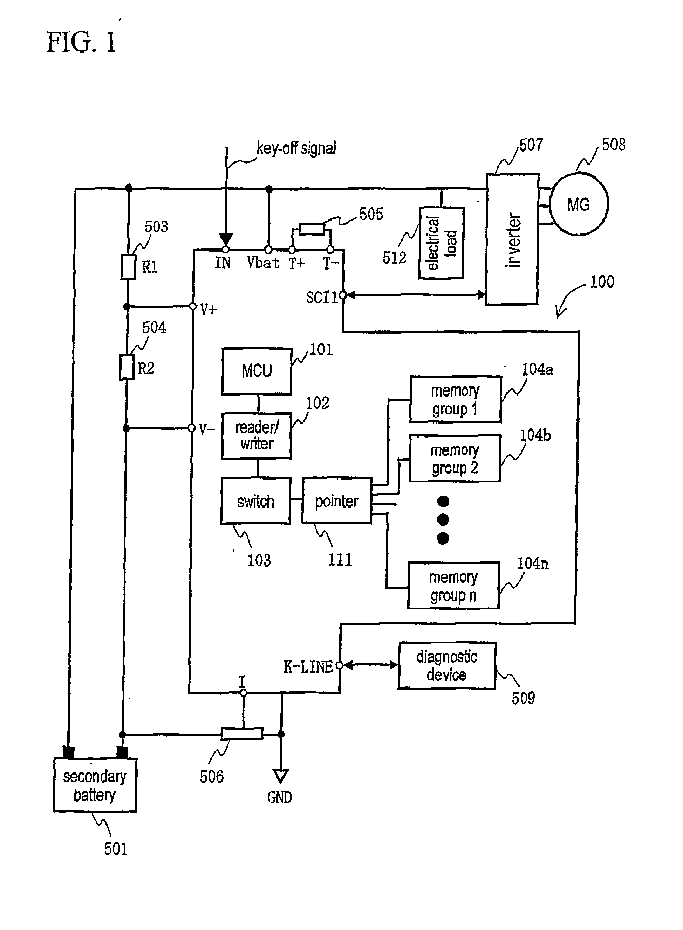

Hereinafter described is Embodiment 1 of a battery controller according to the invention, applied to an electric power train of a hybrid vehicle, with reference to Fig. 1.

The electric power train comprises a motor generator 508 with an inverter 507 controlling power supply thereto from a secondary battery 501 as a power source, and a battery controller 100 for monitoring and so forth of the state of secondary battery 501. In addition, it includes an electrical load 512 such as lights, a heater, and so forth, also using the secondary battery 501 as a power source thereof.

The motor generator 508 is connected to the axle (not shown) of the vehicle to drive it.

The inverter 507 converts DC power of the secondary battery 501 into AC power to drive the motor generator 508. The inverter 507 converts AC power generated by the motor generator 508 into DC power to input it to the secondary battery 501.

The secondary battery (battery power source) 501 serving as an on-board power source is a rechargeable battery such as a lead storage battery, a lithium secondary battery, a nickel-hydrogen battery, an electric double-layer capacitor, and so forth. The secondary battery 501 is connected to a Vbat terminal of the battery controller 100.

The battery controller 100 has V+ terminal and V- terminal, each of which receives, as sensing data (measurement data), an input of partial voltage by dividing the terminal voltage of secondary battery 501 with resistors 503, 504.

The battery controller 100 has T+ terminal and T- terminal, each of which connects a temperature sensor 505, so that a temperature measurement signal is inputted thereto as sensing data (measurement data). The battery controller 100 has I terminal, which connects a current sensor 506, so that a current measurement signal is inputted thereto as sensing data (measurement data).

Further, the battery controller 100 has an SCII terminal serving as a serial communication port, which connects an inverter 507, and has a K-LINE terminal, which connects a diagnostic device 509.

The battery controller 100 incorporates a microcomputer 101, a reader/writer 102, a switch 103, a pointer 111, and memory groups 104a to 104n, each comprising nonvolatile memory.

The microcomputer 101 executes various operations using data stored in the memory groups 104a to 104n and the sensing data on the terminal voltage, current, temperature, and so forth. The operations include, for example, an SOC operation, SOH operation, and detection of malfunction with secondary battery 501 or battery controller 100.

Further, the microcomputer 101 processes writing data into the memory groups 104a to 104n, including writing data on, for example, the number of times that the secondary battery 501 has been put to use, the results of SOC or SOH operations, and the results of detection of malfunction.

The diagnostic device 509 reads, through communication, the results of SOC operation or SOH operation, the results of detection of malfunction with secondary battery 501 or battery controller 100, the number of times that the secondary battery 501 has been put to use, and so forth, stored in the memory groups 104a to 104n. The figure of the present embodiment shows two way communication between the battery controller 100 and the diagnostic device 509 via the K-LINE, however, it is also possible to communicate between them by transmission of data via a power line connected to the secondary battery 501.

Further, the inverter 507, through serial communication with battery controller 100, controls recharging / discharging, according to the results of SOC operation or SOH operation of the battery controller 100.

The battery controller 100 inputs a key-off signal to an external signal input terminal IN. The key-off signal is a signal for reporting that an engine start-key is turned off. Upon receiving this signal, the battery controller 100 writes the results of the various operations, the state of the battery, and so forth into a memory group. The battery controller 100 is also capable of sequentially selecting another memory group, different from the memory group selected, according to such a signal for writing as described above, from outside.

Next, described hereinafter is the explanation of writing to or reading from memory groups 104a to 104n by microcomputer 101.

The microcomputer 101 executes job controls such as power supply to reader/writer 102, switch 103, memory groups 104a to 104n, and so forth.

The reader/writer 102 executes processing for writing data to or reading data from one of the memory groups 104a to 104n, selected by the switch 103, according to a command of the microcomputer 101.

The switch 103, which is also called selector, executes switching the memory groups 104a to 104n for writing or reading data. The switch 103 is made up of a switching device such as a MOS transistor and a logic circuit for controlling the switching device.

The pointer 111 indicates the memory group into which data has been last written. In this embodiment, the pointer 111 is provided between the switch 103 and the memory groups 104a to 104n, but the pointer 111 can alternatively be provided between reader/writer 102 and switch 103 or provided with microcomputer 101 by using suitable software.

The memory groups 104a to 104n are composed of nonvolatile memories such as EEPROMs or flash memories, capable of rewriting or turning power on / off, on the basis of an optional unit. This type of memory device has an upper limit to the number of rewritable times.

The data rewritable into the memory groups 104a to 104n at predetermined intervals includes the results of SOC operation or SOH operation, the results of the detection of malfunction with secondary battery 501 or battery controller 100 by microcomputer 101, the number of times that secondary battery 501 has been put to use, voltage or recharging / discharging current values or temperature of the secondary battery 501, the maximum or minimum or the average value of the voltage, the current, or the temperature, in-service time of the battery, and also the number of rewrite times.

Then, the respective memory group as a target for rewriting is sequentially switched to another from the memory groups 104a to 104n by controlling a pointer for every rewrite time. Accordingly, the number of rewrite times is increased by a factor of "n" as compared with the case of one memory group. As the switch 103 indicates the memory group into which it has written data last, the data in that memory is the latest one at the time of reading.

Alternatively, it is possible to write the number of rewrite times into the respective memory group for every rewrite time. By reading the number of rewrite times at the time of reading, one can get to know which one is new data by the order of the number of rewrite times.

Then, by re-reading the respective memory groups 104a to 104n, one can get to know and utilize the data in the history back to n-times before. Furthermore, it is to reinforce the data-backup function to sequentially switch the respective memory group as a target for rewriting.

Further, it is to enhance redundancy even in the case of failure in rewriting data into one of the memory groups, by concurrently rewriting the same data into the plurality of the memory groups 104a to 104n so that the data can be rewritten into the others of memory groups.

The operation by the battery controller 100 has a feature of being capable of monitoring a change over time in the state of the electrical charge storage means (secondary battery 501). For example, if one memory is to cope with a case of using rewrite information for a period from the present back to ten times before, the memory needs to have a storage capacity sufficient for ten times of rewriting.

Accordingly, by preparing ten memory groups capable of rewriting on an optional unit as with the present invention, the number of rewrite times can be increased by a factor of ten with comparable storage capacity and cost.

Timing of rewrite into the nonvolatile memories of the battery controller 100 is commanded by a signal from a controller such as a write command (signal), data update command (signal), and so forth from an upper-level controller such as a hybrid controller or an engine controller. Further, it is also possible to rewrite and update according to the state inside battery controller 100 by using a processor such as microcomputer 101 in battery controller 100.

Further, as to the timing (the feature) of the rewrite to the nonvolatile memories of the battery controller 100, there can be the time when an engine start-key is turned off or malfunction occurs, and so forth.

When the engine start-key is turned off, power supply to the battery controller 100 is shut off. The type of malfunction includes unintended shutdown of the power source. For these reasons, the battery controller 100 needs to have a backup power source for use in writing into memories.

Further, as described above, it is possible to reduce the operation load of microcomputer 101, and also to reduce the capacities of ROMs and RAMs necessary for the function and operation of microcomputer 101, resulting in reduction in size and cost.

Furthermore, in addition to rewriting on an optional unit, it can be made possible to turned on / off the power source for the memory group as a target for rewriting and reading, so that current consumption in the case of an example described as above can be reduced to one tenth as compared with that for the case of one memory coping with requirements described.

In this case, the switch 103 can be assembled in the reader/writer 102.

The present embodiment significantly improves the upper limit value of the number of rewritable times on memory, so frequent rewriting into the memory becomes possible. Accordingly, it is possible to record the data immediately before turning off an engine start-key or the data immediately before the occurrence of unintended shutdown of the power source, with the result that backup power source for writing into memories can be omitted or that backup time can be shortened.

The switching between memory groups 104a to 104n by switch 103 includes the one to switch the memory group according to the number of rewrite times by the memory group, or to switch the memory according to a predetermined order, or to switch the memory to a predetermined memory group or to a memory group selected in accordance with a predetermined order if an error is found in an error-check following a write-in, or to switch the memory group according to the interior state of battery controller 100, or to switch the memory group according to the instruction signal from the upper-level controller.

These are executed according to the relationship with predetermined set values, or by instruction signals or instruction commands from other controllers.

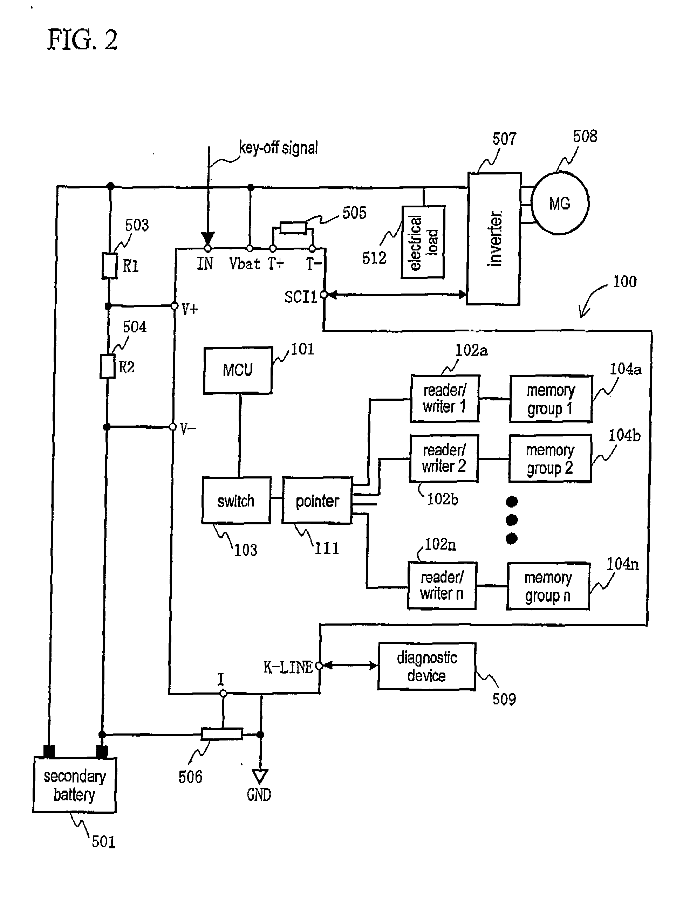

Hereinafter described with reference to Fig. 2 is Embodiment 2 of battery controller according to the invention applied to an electric power train of a hybrid vehicle. In Fig. 2, parts corresponding to those in Fig. 1 are denoted by the same reference numerals, thereby omitting description thereof.

This embodiment is provided with readers/writers 102a to 102n between a pointer 111 and memory groups 104a to 104n such that each of the readers/writers 102a to 102n is mounted in a pair with each of memory groups 104a to 104n.

The present embodiment selects by a switch 103 the reader/writer 102a to 102n at the same time of the selection of the memory group as a target for rewriting and reading.

It is possible to reduce power consumption by on / off controlling of the power source for the readers/writers 102a to 102n and the memory groups 104a to 104n as a target for rewriting and reading.

The present embodiment is, as is Embodiment 1, to increase the number of rewrite times by a factor of "n", to record a history of the preceding data back to n-times before and to reinforce data-backup function, and also to reduce the capacities of ROMs and RAMs necessary for the function and operation of the microcomputer, in spite of increase in the number of readers/writers, resulting in reduction in size and cost. Further, a backup power source for writing into memory can be omitted or backup time can be shortened.

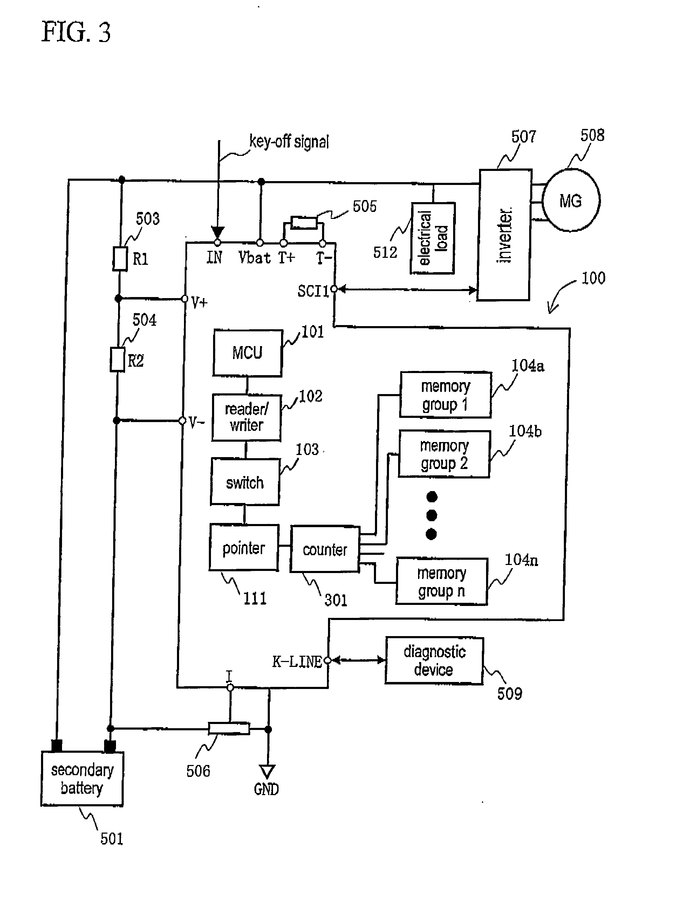

Hereinafter described with reference to Fig. 3 is Embodiment 3 of a battery controller according to the invention applied to an electric power train of a hybrid vehicle.

This embodiment is provided with a counter 301 between a pointer 111 and memory groups 104a to 104n for counting the number of rewrite times into the memory groups 104a to 104n.

With Embodiments 1, and 2, the respective memory groups as the target for rewriting are sequentially changed over in the order of the memory groups 104a to 104n for every rewriting time, however, with the present embodiment, the respective memory groups as the target for rewriting are changed over an optional number of times.

Then, the counter 301 counts the number of times for rewriting to the respective memory groups 104a to 104n, and if the number of times for rewriting to a relevant memory group approaches an upper limit value, control is effected so as to increase frequency of rewriting to others of the memory groups.

More specifically, a microcomputer 101 executes control such that if the number of times for rewriting to the relevant memory group of the memory groups 104a to 104n approaches an upper limit value, the frequency of rewriting to the others of the memory groups is increased.

The present embodiment is effective in the case where a function is assigned to the respective memory groups on the basis of the content of data stored. For example, the memory groups may be divided into a memory group for recording results of various operations, a memory group for storing information on abnormality, and so forth. By so doing, data on the content of stored information is controlled with greater ease.

Further, the counter 301. can be disposed between the microcomputer 101, and a reader/writer 102, or between the reader/writer 102, and a switch 103. Furthermore, the counter 301 can alternatively be implemented by utilizing the function of the microcomputer 101 without installing a physically separate counter.

With the present embodiment, it is possible to increase the number of rewrite times by a factor of "n", to record a history of the preceding data acquired before by n-times of rewrite, to reinforce a data-backup function, and to reduce the capacities of ROMs, and RAMs, necessary for the function and operation of the microcomputer as with the case of Embodiment 1, resulting in reduction in size and cost. Further, a backup power source for use in writing to the memories can be omitted, or backup time can be shortened.

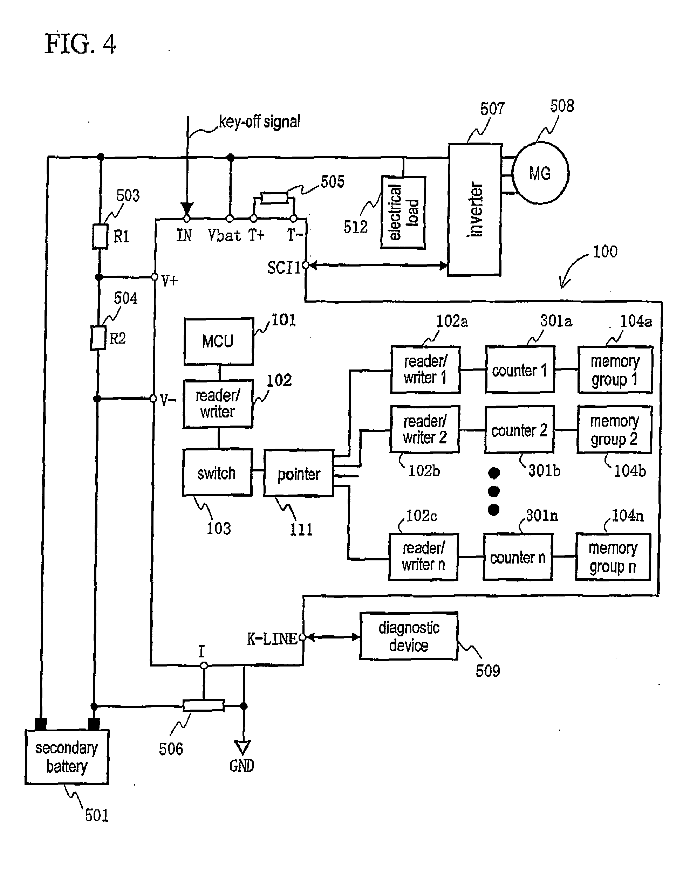

Embodiment 4 of a battery controller according to the invention, applied to an electric power train of a hybrid vehicle, is described hereinafter with reference to Fig. 4. In Fig. 4 as well, parts corresponding to those in Fig. 1 are denoted by like reference numerals, thereby omitting description thereof.

With the present embodiment, readers/writers 102a to 102n, and counters 301a to 301n are provided so as to correspond to respective memory groups 104a to 104n.

With the present embodiment as well, the respective memory groups as a target for rewriting are changed over an optional number of times. Then, the number of times for rewriting to the respective memory groups 104a to 104n is counted by the counters 301a to 301n, respectively, results of which are transmitted to a microcomputer 101.

The microcomputer 101 executes control such that if the number of times for rewriting to a relevant memory group of the memory groups 104a to 104n approaches an upper limit value, frequency of rewriting to others of the memory groups is increased.

The present embodiment as well is effective in the case where a function is assigned to the respective memory groups on the basis of the content of data stored as with the case of Embodiment 3. For example, the memory groups may be divided into a memory group for recording results of various operations, a memory group for storing information on abnormality, and so forth. By so doing, data on the content of stored information is controlled with greater ease.

Further, the present embodiment is effective in making up a memory provided with the readers/writers, the counters, and the waemory groups.

With the present embodiment as well, it is possible to increase the number of rewrite times by a factor of "n", to record a history of the preceding data acquired before by n-times of rewrite, to reinforce a data-backup function, and to reduce the capacities of ROMs, and RAMs, necessary for the function and operation of the microcomputer as with the case of Embodiment 1, resulting in reduction in size and cost. Further, a backup power source for use in writing to the memories can be omitted, or backup time can be shortened.

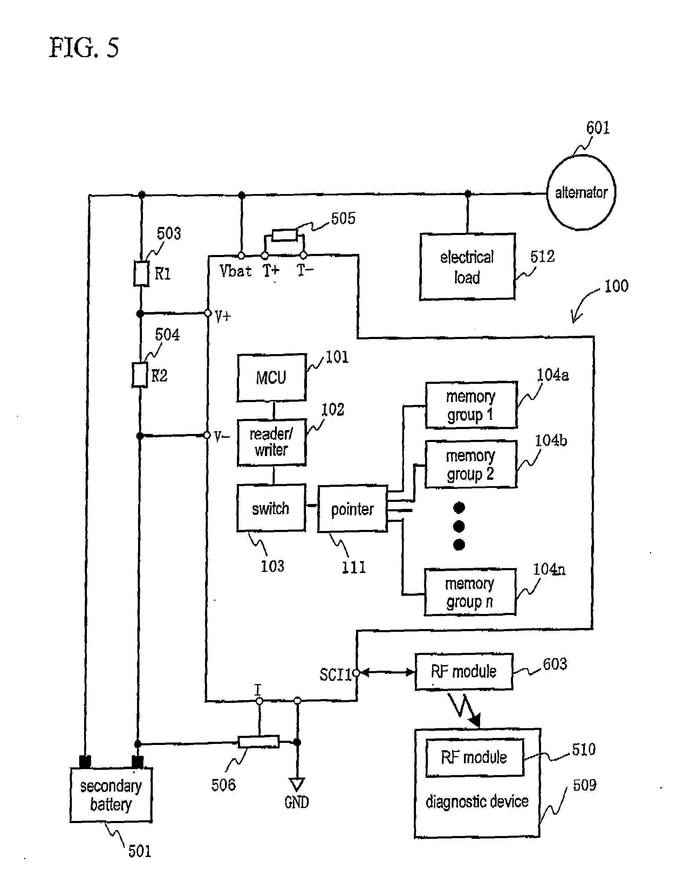

Embodiment 5 of a battery controller according to the invention, applied to a vehicle power supply system, is described hereinafter with reference to Fig. 5. In Fig. 5 as well, parts corresponding to those in Fig. 1 are denoted by like reference numerals, thereby omitting description thereof.

The vehicle power supply system has a secondary battery 501, an alternator 601, an electrical load 512, and a battery controller 100.

The alternator 601 is driven by the motive power of a vehicle engine (not shown) to thereby generate power necessary for the electrical load 512, and charge the secondary battery 501.

A battery controller 100 has an SCII terminal serving as a serial communication port, to which an RF module 603 is connected. The RF module 603 is a wireless communication device for transmitting results of operations by a microcomputer 101, and data stored in memory groups 104a to 104n to a diagnostic device 509 through wireless communication.

The RF module 603 is provided outside the battery controller 100, however, the RF module 603 can be provided inside the battery controller 100.

The diagnostic device 509 incorporates a RF module 510 capable of wireless communication with the RF module 603, and reads information from the battery controller 100 through communication. That is, the diagnostic device 509 serves as an access means for reading, or writing data retained by respective memory groups 104a to 104n to, or from the respective memory groups 104a to 104n from outside.

The diagnostic device 509 assembled in an installation panel at a driver's seat can report in real time a state of the secondary battery 501 to a driver. The driver can take an appropriate step according to the content of a report, such as replacement of the secondary battery 501, and so forth.

Otherwise, the diagnostic device 509 can be assembled in a keyless entry system - capable key. In this case, the driver can take an appropriate step according to the content of a report given by the key, such as replacement of the secondary battery 501, and so forth.

The report in this case includes visual information by means of a liquid crystal display, an LED, and so forth, information based on the sense of hearing such as sound of a buzzer, and so forth, and sensory information such as vibration by a vibrator, and so forth.

With the present embodiment as well, the battery controller 100 incorporates a microcomputer 101, a reader/writer 102, a switch 103, and the memory groups 104a to 104n as with the case of Embodiment 1.

Accordingly, with the present embodiment as well, it is possible to increase the number of rewrite times by a factor of "n", to record a history of the preceding data acquired before by n-times of rewrite, to reinforce a data-backup function, and to reduce the capacities of ROMs, and RAMs, necessary for the function and operation of the microcomputer as with the case of Embodiment 1.

The battery controller 100 shown in Embodiments 2 to 4, respectively, can be applied to the present embodiment as well,

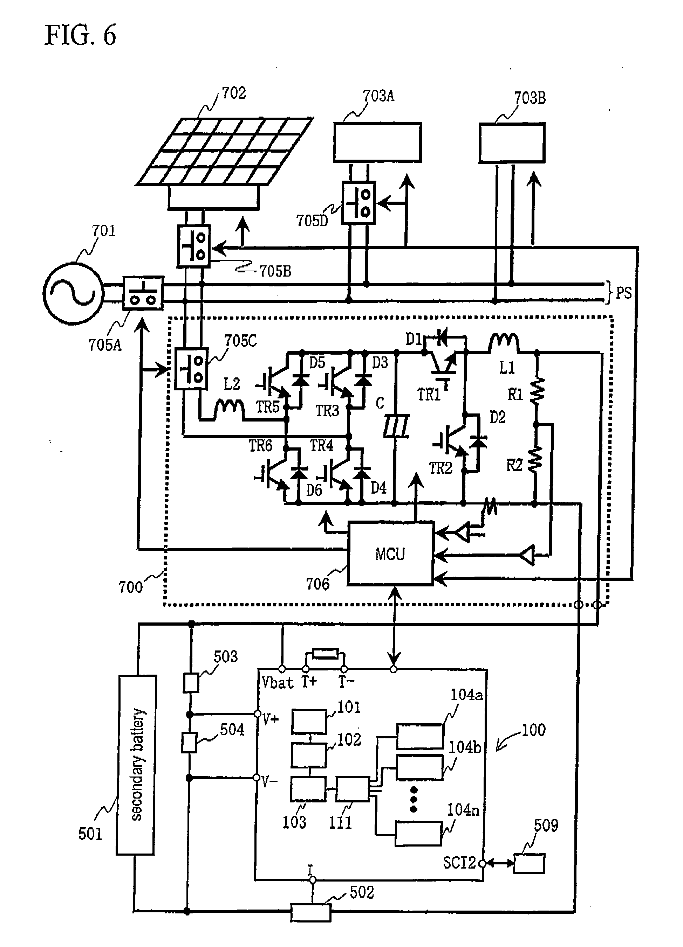

Embodiment 6 of a battery controller according to the invention, applied to a decentralized power storage system, is described hereinafter with reference to Fig. 6. In Fig. 6 as well, parts corresponding to those in Fig. 1 are denoted by like reference numerals, thereby omitting description thereof.

With the decentralized power storage system, a controlled converter 700, a commercial power source 701, a photovoltaic power generation system 702, and a load apparatus 703A are selectively turned on / off for connection with a power line PS by changeover devices 705A, 705B, 705C, and 705D, respectively. Further, another load apparatus 703B is connected to the power line PS. The both ends of a secondary battery 501 are connected to the controlled converter 700. Further, those respective units of equipment described may have a changeover device therein.

The photovoltaic power generation system 702 is a system for converting the sunshine into DC power with the use of solar cells to thereby output AC power by means of an inverter.

The load apparatuses 703A, 703B include household electrical appliances such as an air-conditioner, a refrigerator, a microwave oven, lights, and so forth, electrical equipment such as an electric motor, an elevator, a computer, medical equipment, and so forth, and a second power source.

The controlled converter 700 comprising a MCU 706 is a charge / discharge device for converting AC power into DC power, or converting DC power into AC power. The MCU 706 is connected to the changeover devices 705A, 705B, 705C, 705D, and the load apparatus 703B, respectively, so as to enable bidirectional communication therewith. As a result, the controlled converter 700 doubles as a controller for controlling charge / discharge, and controlling equipment such as the photovoltaic power generation system 702, the load apparatuses 703A, 703B, and so forth.

Further, a battery controller 100 as well is connected to the controlled converter 700 via a serial communication terminal SC11 so as to enable serial communication therewith.

With this application example (the present embodiment), in case that the commercial power source 701, and the photovoltaic power generation system 702 are unable to fully accommodate power required by the load apparatuses 703A, 703B, power is supplied from the secondary battery 501 via the controlled converter 700. Meanwhile, in the case of excessive power supply from the commercial power source 701, and the photovoltaic power generation system 702, electrical charge is stored in the secondary battery 501 via the controlled converter 700.

During those jobs, the battery controller 100 executes various operations by use of data stored in memory groups 104a to 104n, and sensing data. The battery controller 100 executes operations such as, for example, an SOC operation, SOH operation, detection of abnormality with the secondary battery 501, and the battery controller 100, and so forth. Then, the battery controller 100 sends out operation results concerning the state of the secondary battery 501, and results of the detection of abnormality to the controlled converter 700. In response thereto, the controlled converter 700 controls charge / discharge, and so forth.

More specifically, during those jobs, the battery controller 100 executes various operations by use of data stored in the memory groups 104a to 104n, and sensing data, including, for example, the SOC operation, SOH operation, the detection of abnormality with the secondary battery, and the battery controller, and so forth.

Further, there is executed an operation on data to be stored in the memories including, for example, the number of times that the battery has been put to use, the operation results described as above, the results of the detection of abnormality, and so forth.

Then, the results of the operation on the state of the secondary battery 501, and the results of the detection of abnormality are sent out to the controlled converter 700. In response thereto, the controlled converter 700 controls the charge /discharge, and so forth.

Furthermore, at the time of a periodical inspection or trouble diagnostics, a diagnostic device 509 is used to thereby read by communication the results of the SOC operation and SOH operation stored in the memory groups 104a to 104n, the results of the detection of abnormality with the secondary battery, and the battery controller, the number of times that the battery has been put to use, and so forth.

By so doing, the content of the periodical inspection or the trouble diagnostics can be substantiated, and it will take less time in carrying out those jobs.

Further, since the states of the battery controller 100 and the secondary battery 501, respectively, can be detected, it becomes possible to make full use of the secondary battery 501 safely and effectively.

Still further, since the present embodiment is provided with the secondary battery 501, it becomes possible to lower contracted power of the commercial power source 701, power consumption, and power generation rating for the photovoltaic power generation system 702, leading to reduction in installation cost and running cost. By supplying power from the secondary battery 501 to the commercial power source 701 when convergence of power consumption occurs in a certain time zone, and by storing power in the secondary battery 501 at the time of low power consumption, it is possible to level off power consumption.

Yet further, as the controlled converter 700 monitors power consumption of the load apparatuses 703A, 703B to thereby control the same, it is possible to achieve energy saving and effective use of power.

With the present embodiment as well, the battery controller 100 incorporates a microcomputer 101, a reader/writer 102, a switch 103, and the memory groups 104a to 104n as with the case of Embodiment 1.

Accordingly, with the present embodiment as well, it is possible to increase the number of rewrite times by a factor of "n", to record a history of the preceding data acquired before by n-times of rewrite, to reinforce a data-backup function, and to reduce power consumption, and the capacities of ROMs, and RAMs, necessary for the function and operation of the microcomputer as with the case of Embodiment 1.

Further, the battery controller 100 shown in Embodiments 2 to 4, respectively, can be applied to the present embodiment as well.

Features, components and specific details of the structures of the above-described embodiments may be exchanged or combined to form further embodiments optimized for the respective application. As far as those modifications are readily apparent for an expert skilled in the art they shall be disclosed implicitly by the above description without specifying explicitly every possible combination, for the sake of conciseness of the present description.

## Claims

1. A battery controller for measuring at least one of voltage, current, and temperature of a secondary battery (501) to process state information on the secondary battery (501), the battery controller including a memory for storing state information on the secondary battery (501),
wherein the memory comprises:
a plurality of memory groups (104) comprising nonvolatile memories rewritable on the basis of one unit or plural units;
a switch (103) for selecting the memory groups (104); and
a reader/writer (102) for writing or reading state information on the secondary battery (501) into or from a memory group (104) as selected.

2. A battery controller for measuring at least one of voltage, current, and temperature of a secondary battery to process state information on the secondary battery (501), including:
a memory for storing state information on the secondary battery (501),
a plurality of memory groups (104) comprising nonvolatile memory groups comprising nonvolatile memories rewritable on the basis of one unit or plural units;
readers/writers (102) of data, each of which is mounted in correspondence with each of the nonvolatile memory groups (104), and
a switch (103) for selecting a memory group (104) and a reader/writer (102) in correspondence with said memory group (104), wherein
the selection of a memory group (104) as well as a reader/writer (102) is executed by the switch (103), and
the state information on the secondary battery (501) is written into or read from the memory group (104) and the reader/writer (102) as selected.

3. The battery controller according to claim 1 or claim 2, wherein the switch (103) selects sequentially a memory group (104) other than the one already selected, according to a signal for writing from outside.

4. The battery controller according to at least one of claims 1 to 3, wherein the battery controller comprises a counter (301) for the number of rewrite times of memory groups (104), and
the switch (103) selects a memory group (104) according to the number of times of writing into the memory groups (104), as counted by the counter.

5. The battery controller according to at least one of claims 1 to 4, wherein the switch (103) selects a memory group (104) according to the error information in writing into the memory group (104) as selected,

6. The battery controller according to at least one of claims 1 to 5, wherein the battery controller comprises an access means for reading data stored in the memory groups (104) or writing data into the memory groups (104), from outside.

7. The battery controller according to at least one of claims 1 to 6, wherein the access means has a communication circuit for sending or receiving the state information on the secondary battery (501) to read or write data from or into an external equipment by means of wireless communication.
